# EUROPÄISCHE PATENTSCHRIFT

(11) **EP 1 191 697 B1**
(45) Veröffentlichungstag und Bekanntmachung des Hinweises auf die Patenterteilung: **21.12.2011**
(21) Anmeldenummer: 01810722.7
(22) Anmeldetag: 20.07.2001
(51) Int. Cl.: H03D 9/00, H03L 7/18

(54) **Lokaloszillator zur Erzeugung eines HF-Signals zur Direktmischung mittels Avalanche-Fotodioden**
Local Oscillator for the Generation of an HF-Signal to be Directly Mixed by Avalanche-Photodiodes
Oscillateur local pour la génération d'un signal HF pour le mélange direct par photodiodes à avalanches

(30) Priorität: 27.12.2000 DE 10065353; 31.07.2000 DE 10037209
(43) Veröffentlichungstag der Anmeldung: 27.03.2002
(73) Patentinhaber: HILTI Aktiengesellschaft, 9494 Schaan (LI); JENOPTIK Laser, Optik, Systeme GmbH, 07745 Jena (DE)
(72) Erfinder: Gogolla, Torsten, 6820 Frastanz (AT); Winter, Andreas, 6800 Feldkirch (AT); Seifert, Helmut, 07616 Serba (DE)
(74) Vertreter: Wildi, Roland

(56) Entgegenhaltungen:
- WO-A-99/21272
- US-A- 5 400 130
- US-A- 6 052 190
- PATENT ABSTRACTS OF JAPAN vol. 007, no. 251 (E-209), 8. November 1983 (1983-11-08) & JP 58 137304 A (ZENERARU:KK), 15. August 1983 (1983-08-15)
- KULCZYK W K ET AL: "THE AVALANCHE PHOTODIODE AS AN ELECTRONIC MIXER IN A OPTICAL RECEIVER" IEEE TRANSACTIONS ON ELECTRON DEVICES, IEEE INC. NEW YORK, US, Bd. ED-19, Nr. 11, 1. November 1972 (1972-11-01), Seiten 1181-1190, XP002040605 ISSN: 0018-9383

## Beschreibung

Die Erfindung betrifft einen Lokaloszillator zur Erzeugung eines schmalbandigen Hochfrequenz-Signals (HF-Signals) zur direkten Signalmischung mit einem über eine in Sperrrichtung vorgespannte Avalanche-Fotodiode (APD) aus einem auf die APD auftreffenden Lichtsignal erzeugten Empfangssignal.

Avalanche-Fotodioden (APDs) werden unter anderem in empfindlichen optoelektronischen Messsystemen eingesetzt. So ist beispielsweise die optoelektronische Messung von Distanzen bis zu 100 m mit Genauigkeiten von wenigen Millimetern für zahlreiche Anwendungen, insbesondere in der Bauindustrie und im Anlagenbau von großer Bedeutung. Die Dynamik derartiger Entfernungsmessysteme sollte möglichst hoch sein, um sowohl sehr schwache als auch starke Lichtempfangssignale verarbeiten zu können. Hierdurch wird die Verwendung definierter Zielmarken am Objekt, dessen Distanz von einem Referenzort aus bestimmt werden soll, überflüssig. Die Möglichkeit der direkten Distanzmessung an bestimmten Oberflächen, d. h. ohne den Einsatz von Zielmarken, ermöglicht insbesondere bei den genannten technischen Gebieten und Branchen reduzierte Fertigungszeit und Kosteneinsparungen bei gleichzeitiger Verringerung der Fertigungstoleranzen.

Um die geforderte hohe Dynamik gewährleisten zu können und zur Detektion sehr schwacher Messsignale ist der Einsatz von empfindlichen APDs vielfach unumgänglich und prinzipiell bei Verfahren und Einrichtungen zur hochgenauen optoelektronischen Distanzmessung auch bekannt. In den meisten Fällen wird bei Distanzmesseinrichtungen ein vorzugsweises sinusförmig intensitätsmodulierter Strahl einer Lichtquelle, insbesondere einer Laserdiode, auf ein Messobjekt gerichtet (vergleiche EP 0 701 702 B1, DE 196 43 287 A1, US 4,403,857). Das vom Messobjekt zurückgestreute intensitätsmodulierte Licht wird von einer Fotodiode detektiert. Die zu messende Distanz ergibt sich aus der Phasenverschiebung der vom Messobjekt zurückgestreuten sinusförmig modulierten Lichtintensität in Bezug zur emittierten Lichtintensität der Lichtquelle. Um bei hochgenauen Distanz- bzw. Phasenmesssystemen eine Eliminierung von temperatur- sowie alterungs- und empfangsleistungsabhängigen Phasenfehlern zu erreichen, wurde mit der DE-Patentanmeldung 100 06 493.0 als Verbesserung gegenüber der Messeinrichtung nach US 4,403,857 vorgeschlagen, die Lichtintensitäten eines Haupt- und eines Referenzemitters gleichzeitig mit verschiedenen Modulationsfrequenzen zu modulieren und aufgrund de Verwendung von APDs als Haupt- und Referenzempfänger ein Signalgemisch zu erzeugen, welches ein Signal mit der Intensitätsmodulationsfrequenz des Hauptemitters einerseits und ein Signal mit der Intensitätsmodulationsfrequenz des Referenzemitters andererseits enthält. Durch simultane Messung der Phasen der beiden so erzeugten Signale und Trennung beider Phasen in einem Zwischenfrequenzbereich ist eine störungsfreie Distanzmessung mit eindeutiger Distanzaussage möglich.

Die US 5,400,130 beschreibt ein Distanzmessgerät, bei dem ei n von einem fotoelektrischen Detektor empfangenes, hochfrequentes Signal zur weiteren Auswertung in einem Mischer auf eine niederfrequente Zwischenfrequenz umgesetzt wird.

Da bei großen Distanzen und technischen Messobjektflächen, also ohne die Verwendung von Zielmarken, mit sehr schwachen Signalen zu rechnen ist, wird der Einsatz der empfindlichen APDs notwendig, die beispielsweise im Vergleich zu PIN-Fotodioden eine zusätzliche innere Verstärkung des Fotostroms bewirken, der durch die einfallende Lichtleistung generiert wird. Diese innere Verstärkung resultiert aus einer Ladungsträgervervielfachung in der Lawinenzone der APD, in der eine hohe elektrische Feldstärke existiert. Durch diese Feldstärke werden die durch den Lichteinfall generierten Ladungsträger stark beschleunig, so dass sie aufgrund ihres hohen Energiezustands weitere Ladungsträger aus dem Halbleitermaterial der APD herauslösen, die zur zusätzlichen Verstärkung des Fotostroms führen.

Zur Erzeugung der hohen elektrischen Feldstärken in der Lawinenzone der APD wird eine hohe Spannung in Sperrrichtung benötigt. Sie liegt je nach APD-Typ im Bereich von 40 V bis 500 V. Typische Verstärkungsfaktoren der Fotoströme liegen zwischen 10 und 200. Sie hängen stark vom jeweiligen Halbleitermaterial (z. B. Si, InGaAs), dem Aufbau der Fotodiode, der Sperrspannung und der Temperatur ab.

Ein bereits erwähntes Problem bei der beschriebenen Art der optoelektronischen Distanzmessung, insbesondere an technischen Oberflächen ist die Detektion sehr schwacher Signale. Dabei dürfen in dem Messsystem nur sehr geringes störendes elektronisches Rauschen und nur sehr schwaches elektrisches Übersprechen (z. B. <110 dB) vom Lichtsender (Laser) zum Fotodiodenempfänger vorhanden sein.

Um ein nur schwaches Übersprechen und eine möglichst geringe Einkopplung von externen Störfeldern (Funkfelder, digitale Störungen) zu gewährleisten, kann im Empfänger eine Methode der direkten Signalmischung angewandt werden, wie sie beispielsweise aus der bereits erwähnten US 4,503,857, sowie aus einem Fachaufsatz K. Seta, T. Oh' Ishi "Distance Measurement Using a Pulse Train Emitted from a Laser Diode", Japanese J. of Appl. Physics, Band. 26, Nr. 10, S. L1690-L1692, Oktober 1987 bekannt ist und in einer speziellen vorteilhaften Abwandlung auch in der ebenfalls bereits erwähnten DE-Patentanmeldung 100 06 493.0 vorgeschlagen worden ist. Bei einer solchen Direktmischung wird der APD-Sperrspannung das (vorzugsweise) sinusförmige Signal der Frequenz f_{LO} eines Lokaloszillators und einer Amplitude von >1 V überlagert, so dass mit der Sperrspannung auch der Verstärkungsfaktor M der APD, d. h. ihre innere Stromquelle, moduliert wird. Für den APD-Ausgangsstrom gilt dabei in erster Näherung i_{APD}(t) = M(t)·i_{FOTO}(t), wobei M(t) die von der Zeit t abhängige modulierte APD-Verstärkung und i_{FOTO}(t) den inneren, durch den Lichteinfall generierten Fotostrom beschreiben. Aufgrund des nichtlinearen Zusammenhangs zwischen der APD-Verstärkung und dem inneren Fotostrom entsteht ein Mischprodukt, d. h. ein Zwischenfrequenzsignal (ZF-Signal), das mit der Frequenzdifferenz zwischen der Frequenz f_{LO} des Lokaloszillators und der Frequenz f_{MESS} der modulierten detektierten Lichtleistung oszilliert. Die Frequenzumsetzung findet demnach in der inneren Stromquelle der APD statt. Durch Tiefpassfilterung lassen sich höherfrequente Anteile eliminieren. Das Ausgangssignal der APD, d. h. das ZF-Signal ist (vergleichsweise) niederfrequent und lässt sich somit problemlos weiterverarbeiten. Da sich der Mischprozess innerhalb des Chips der APD abspielt, sind die Strukturgrößen der Mischanordnung typischerweise um drei bis vier Größenordnungen kleiner als die verwendete Modulationswellenlänge. Hierdurch wird die Einstreuung externer elektromagnetischer Störleistung und das elektrische Übersprechen weitgehend vernachlässigbar. Eingestreute Störleistung führt grundsätzlich auch zu erhöhtem Rauschen. Durch die beschriebene Maßnahme werden also auch die Rauscheigenschaften deutlich verbessert. Vorteilhaft ist auch, dass das aus der Direktmischung hervorgehende ZF-Signal in der Regel vergleichsweise sehr niederfrequent ist; z. B. 10 kHz bis 100 kHz. In diesem Frequenzbereich sind keine Störeinstreuungen zu erwarten. Auch parasitäre Eigenschaften von sonstigen elektronischen Bauelementen sind bei diesen niedrigen Frequenzen vernachlässigbar. Da das Ausgangssignal der APD im ZF-Bereich liegt, werden im Empfangsteil außer dem Lokaloszillator keine weiteren Hochfrequenzbauteile benötigt. Die Herstellungskosten aber auch der Stromverbrauch eines mit solchen APDs ausgerüsteten optoelektronischen Distanzmesssystems lassen sich also drastisch reduzieren.

Eine Abtastvorrichtung, bei der in einer APD ein hochfrequentes Messsignal empfangen und auf eine Zwischenfrequenz heruntergemischt wird, wobei in der APD das empfangene hochfrequente Lichtsignal mit einer Referenzfrequenz gemischt wird, die in einem üblichen VCO (voltage control oscillator) gebildet wird, ist in der US 6,052,190 beschrieben.

Dabei ergibt sich jedoch ein Problem, das der Erfindung als Aufgabe zugrundeliegt: Aufgrund der erwünschten und prinzipiell auch realisierbaren geringen Leistungsaufnahme des in der Regel aus einer möglichst kleinen Batterie zu betreibenden Distanzmessgeräts können bekannte handelsübliche PIL-Oszillatoren (PLL = Phase Locked Loop) mit nachgeschaltetem 50-Ohm-HF-Verstärker zur Erzeugung des Lokaloszillatorsignals für die Frequenzmischung nicht oder nur mit unbefriedigendem Ergebnis verwendet werden. Da eine Avalanche-Fotodiode eine rein kapazitive Last darstellt, diese HF-Verstärker aber für einen stabilen Betrieb einen niederohmigen 50-Ohm-Signalabschluss benötigen, muss für den Verstärker eine mit Leistungsverbrauch verbundene Zwangsanpassung vorgesehen werden. Bei einer erwünschten Amplitude von beispielsweise 2 V wäre hierzu beispielsweise eine HF-Leistung von 40 mW notwendig. Dies ist aber mit der angestrebten geringen Stromaufnahme nicht realisierbar.

Gemäß dem erwähnten Fachaufsatz K. Seta et al. soll zur Signalabschlussanpassung des notwendigen HF-Verstärkers ein Hochfrequenzübertrager verwendet werden. In der Praxis hat sich dies jedoch ebenfalls als problematisch erwiesen, da für die benötigten hohen Frequenzen des Lokaloszillatorsignals (z. B. 1 GHz) nur Spannungsübersetzungen von 1:2 verfügbar sind und zusätzlich erhebliche EMI-Probleme aufgrund der Verwendung des Übertragers auftraten.

Die erfindungsgemäße Lösung sieht einen Lokaloszillator zur Erzeugung eines schmalbandigen HF-Signals zur Direktmischung mit einem über eine in Sperrrichtung vorgespannte Avalanche-Fotodiode (APD) aus einem einfallenden Lichtsignal erzeugten (ersten) Empfangssignal vor, bei dem die Sperrschichtkapazität der APD in einen steuerbaren HF-Resonanzkreis einbezogen ist, dessen das HF-Signal bildende Resonanzfrequenz durch wählbare Einstellungen einer von einem Referenzoszillator beaufschlagten Steuereinheit bestimmt ist.

Die Erfindung geht von dem Gedanken aus, die Sperrschichtkapazität der gleichzeitig als Direktmischer verwendeten APD als schwingungs(mit)bestimmendes Element in einen insbesondere PLL-stabilisierten HF-Oszillator einzubinden, wobei vor allem ein LC-Oszillator im Vordergrund des Interesses steht. Durch diesen PLL-stabilisierten Betrieb wird nicht nur die geforderte

Schmalbandigkeit des Lokaloszillatorsignals gewährleistet, welches für die Mischung mit dem als Messsignal verwendeten Empfangssignal benötigt wird. Es wird außerdem eine vergleichsweise hohe Spannungsamplitude bei geringer Leistungsaufnahme erreicht. Das einstellbare Teilerverhältnis der PLL-Schaltung zusammen mit der Frequenz des Referenzoszillators bestimmt dabei die Eigenfrequenz des HF-Resonanzkreises.

Eine besonders vorteilhafte und einfache Lösung ergibt sich, wenn der HF-Resonanzkreis als LC-Resonanzkreis aufgebaut ist, dessen Resonanzfrequenz durch eine zur Sperrschichtkapazität parallel oder in Serie geschaltete und durch die PLL-Schaltung steuerbare Kapazität insbesondere eine Kapazitätsdiode eingestellt wird. Eine alternative oder ergänzende Möglichkeit besteht darin, einen frequenzmäßig steuerbaren zur Sperrschichtkapazität der APD parallel oder in Serie liegenden HF-Resonanzkreis durch eine steuerbare Induktivität zu realisieren, wobei beispielsweise an einen als Induktivität wirkenden steuerbaren Transistor zu denken ist.

Der HF-Resonanzkreis, in den die Sperrschichtkapazität der APD eingebunden ist, kann auch mittels eines Resonators realisiert sein, der entweder direkt steuerbar ist oder durch zusätzliche Verwendung einer steuerbaren Kapazität und/oder einer steuerbaren Induktivität. Als derartige Resonatoren kommen beispielsweise Quarze, dielektrische Keramikresonatoren, Hohlraumresonatoren oder Leitungsresonatoren in Frage, deren Ersatzschaltbilder, wie dem Fachmann geläufig, einem LC-Kreis entsprechen.

Vorteilhafte Weiterbildungen und Ausgestaltungen des Erfindungsgedankens sind in abhängigen Patentansprüchen enthalten und werden nachfolgend auch in Verbindung mit der Beschreibung von Ausführungsbeispielen der Erfindung mit Bezug auf die Fig. 1 bis 7 näher erläutert.
- **Fig. 1**: zeigt ein erstes Ausführungsbeispiel für einen erfindungsgemäßen Lokaloszillator, realisiert als PLL-stabilisierter LC-Parallelschwing- kreis mit einer zur Sperrschichtkapazität einer APD parallel geschalteten Kapazitätsdiode.
- **Fig. 2**: zeigt eine Abwandlung des ersten Ausführungsbeispiels, bei der die PLL-Schaltung von Fig. 1 durch einen digitalen Regelkreis ersetzt ist.
- **Fig. 3**: veranschaulicht ein zweites Ausführungsbeispiel eines erfindungs- gemäßen Lokaloszillators auf Basis eines LC-Parallelschwingkreises mit einer zur Sperrschichtkapazität der APD in Serie geschalteten Kapazitätsdiode.
- **Fig. 4**: zeigt ein drittes Ausführungsbeispiel des erfindungsgemäßen Lokaloszillators auf Basis eines LC-Seienschwingkreises.
- **Fig. 5**: zeigt ein viertes Realisierungsbeispiel für einen erfindungsgemäßen PLL-stabilisierten LC-Oszillator, bei dem zwei hochfrequenzmäßig parallel geschaltete APDs vorhanden sind, die in einen LC-Parallel- resonanzkreis eingebunden sind.
- **Fig. 6**: veranschaulicht ein weiteres abgewandeltes Realisierungsbeispiel eines PLL-stabilisierten LC-Oszillators, bei dem zwei APDs sowohl hochfrequenzmäßig als auch gleichspannungsmäßig parallel geschaltet sind.
- **Fig. 7**: zeigt ein sechstes Realisierungsbeispiel eines PLL-stabilisierten LC- Oszillators, bei dem die zwei APDs hochfrequenzmäßig parallel geschaltet und in einen LC-Serienresonanzkreis eingebunden sind.
- **Fig. 8**: zeigt ein siebtes Realisierungsbeispiel eines PLL-stabilisierten LC- Oszillators, bei dem zwei APDs hochfrequenzmäßig in Serie geschaltet und in einen LC-Serienresonanzkreis eingebunden sind.

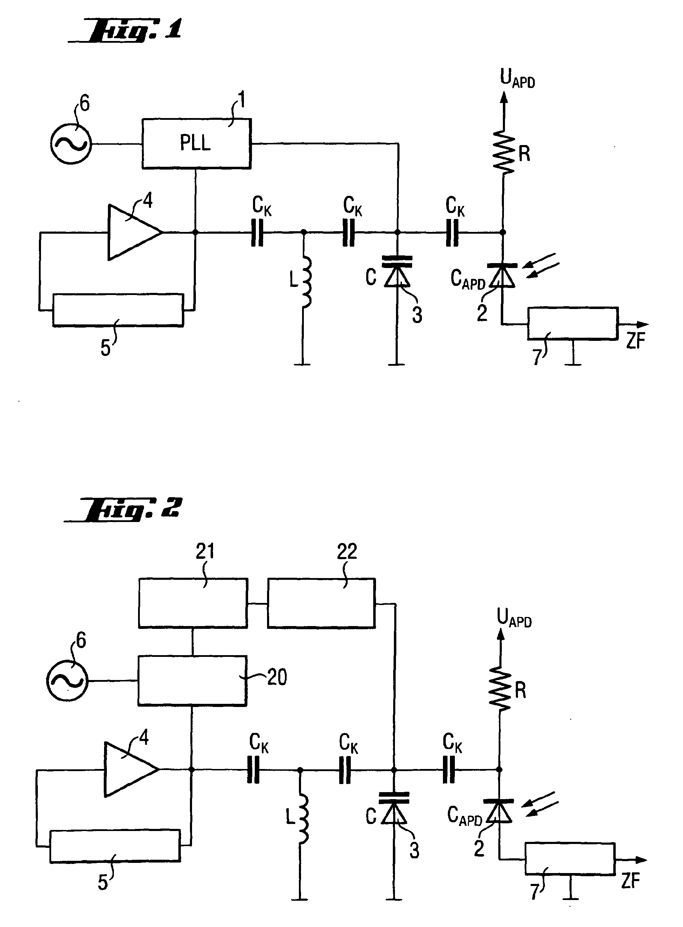

Es wird zunächst auf die Fig. 1 Bezug genommen.

Über einen ohmschen Widerstand R wird einer beispielsweise als Messsignalempfänger dienenden APD 2 eine Hochspannung in Sperrrichtung zugeführt. Zur Sperrschichtkapazität C_{APD} der APD 2 ist die Kapazität C einer Kapazitätsdiode 3 sowie eine Induktivität L HF-signalmäßig parallel geschaltet. Diese Schaltungsanordnung bildet einen LC-Parallelresonanzkreis, der bei seiner Resonanzfrequenz im Leerlauf betrieben wird. Die in der Schaltung zwischen den kathodenseitigen Fußpunkten der APD 2 und der Kapazitätsdiode 3 und der Induktivität L sowie zwischen der Induktivität L und dem Ausgang eines HF-Verstärkers 4 vorhandenen Koppelkapazitäten C_{K} stellen für das Signal mit der Resonanzfrequenz einen Kurzschluss dar. Sie dienen lediglich, wie dem Fachmann geläufig, zum Entkoppeln der verschiedenen an die APD 2, die Kapazitätsdiode 3 und die Induktivität L anzulegenden Gleichspannungen. Das direkt in der APD 2 gebildete Mischprodukt aus dem Empfangssignal der APD 2 und dem über den erfindungsgemäßen LC-Oszillator erzeugten schmalbandigen HF-Signal gewonnene ZF-Signal lässt sich über einen Tiefpass 7 auf der Anode der APD 2 abgreifen. Der Tiefpass 7 kann beispielsweise für die HF-Signale, d. h. für das Empfangssignal der APD 2 und für das aus dem LC-Oszillator hervorgehende Lokaloszillatorsignal, einen kapazitiven Kurzschluss nach Masse darstellen, wobei jedoch das ZF-Signal ungehindert passieren kann. Außerdem wird durch den Tiefpass 7 die Anode der APD 2 über einen relativ hochohmigen Widerstand auf Masse geführt, so dass dort ein Gleichspannungsanteil von nahezu 0 Volt resultiert. Der HF-Verstärker 4, z. B. in Form eines Hochfrequenztransistors, ermöglicht zusammen mit einem für den Fachmann hier nicht näher zu beschreibenden, da prinzipiell bekannten Rückkopplungsnetzwerk 5 ein sicheres Anschwingen des LC-Oszillators. Außerdem werden auf diese Weise Verluste ausgeglichen und eine Oszillation konstanter Amplitude gewährleistet. Die Kapazität C der in Sperrrichtung geschalteten Kapazitätsdiode 3 ist abhängig von ihrer jeweils anliegenden Sperrspannung. Ein kleiner Anteil des LC-Oszillatorsignals wird zusammen mit dem Ausgangssignal des Verstärkers 4 einer PLL-Schaltung 1 zugeführt, in der die Frequenz des LC-Oszillatorsignals heruntergesetzt wird, z. B. mit einem Frequenzteiler, und anschließend mit einem von einem Referenzoszillator 6 erzeugten phasenstarren Referenzoszillatorsignal hinsichtlich Phasenlage verglichen wird. Die PLL-Schaltung 1 regelt durch Variation der Sperrspannung der Kapazitätsdiode 3 die Diodenkapazität C und damit die Resonanzfrequenz des LC-Oszillators so, dass sich Phasengleichheit zwischen dem frequenzreduzierten LC-Oszillatorsignal und dem Referenzoszillatorsignal einstellt. In diesem Fall nimmt die Resonanzfrequenz des LC-Oszillators einen Sollwert an, der abhängig ist von dem einstellbaren Teilerverhältnis des Frequenzteilers der PLL-Schaltung 1 und der Frequenz des Referenzoszillators 6. Dabei ist es von Vorteil, wenn der Referenzoszillator 6 der gemeinsame Mutteroszillator des Gesamtsystems, also insbesondere und beispielshalber der optoelektronischen Distanzmesseinrichtung ist.

Wichtig für die Erfindung ist, dass die Resonanzfrequenz des LC-Oszillators nur abhängig ist von dem frei wählbaren Teilerverhältnis der PLL-Schaltung 1 und der Frequenz des Referenzoszillators 6. Sie hängt insbesondere nicht von der Sperrschichtkapazität C_{APD} der APD 2 ab, die mit erheblichen Exemplarstreuungen verbunden sein kann und die zudem temperatur-, spannungs- und empfangsleistungsabhängig ist. Durch die steuerbare Kapazität C der Kapazitätsdiode 3 werden Schwankungen der APD-Kapazität C_{APD} vollständig kompensiert.

Da die temperatur- und empfangsleistungsabhängigen Kapazitätsschwankungen der APD 2 das Phasenverhalten des Lokaloszillatorsignals und somit auch das Phasenverhalten des über die APD 2 erhaltenen Empfangssignals, insbesondere Messsignals, im Zwischenfrequenzbereich beeinflussen, wird gleichzeitig ein hieraus hervorgehender Distanzmessfehler eliminiert. Es stellt sich also unabhängig von störenden Umgebungsbedingungen automatisch immer ein definierter Systemzustand ein. Auch andere störende parasitäre Schaltungskapazitäten werden kompensiert.

Bei der Resonanzfrequenz wird außerdem durch die Parallelschaltung der Induktivität L der tiefpassbegrenzende Einfluss der Schaltungskapazitäten beseitigt, und zwar unabhängig von Exemplarstreuungen, der Temperatur, der APD-Sperrspannung und der Empfangsleistung. Dies führt zu einer Erhöhung der oberen Grenzfrequenz der Schaltung.

Mit dem programmierbaren Teilerverhältnis der PLL-Schaltung 1 lassen sich die beschriebenen definierten, schmalbandigen Systemzustände bei beliebigen, im Freuquenzeinfangbereich der PLL-Schaltung 1 liegenden Frequenzen realisieren.

Als alternative Möglichkeit kann die PLL-Schaltung durch einen digitalen Regelkreis nach Fig. 2 ersetzt werden. Hierbei wird der Istwert der Frequenz des aus dem LC-Oszillator hervorgehenden Lokaloszillatorsignals mit einem Frequenzzähler 20 unter Verwendung des Referenzoszillatorsignals ständig gemessen und anschließend einer Steuereinheit 21 zugeführt. Die Steuereinheit 21 wird vorzugsweise durch einen Digitalrechner, also beispielsweise einen Microcontroller oder einen Signalprozessor gebildet. Auf Basis der ständig gemessenen Frequenz-Istwerte erzeugt die Steuereinheit 21 über einen Regelalgorithmus mit einem Digital-Analog-Wandler 22 geeignete Steuerspannungen, mit denen die Kapazitätsdiode 3 beaufschlagt wird, so dass die Resonanzfrequenz einen vorgegebenen und stabilisierten Sollwert annimmt. Schwankungen bei den LC-Resonatorgrößen, Sperrschichtkapazität C_{APD} und Induktivität L werden also durch eine vom Regelalgorithmus über die Steuerspannnung veränderte Kapazität C der Kapazitätsdiode 3 ausgeglichen.

Es ist auch ein ungeregeltes System denkbar. Hierbei wird die Resonanzfrequenz über die Steuerspannung der Kapazitätsdiode 3, die von der Steuereinheit 21 mit dem Digital-Analog-Wandler 22 erzeugt wird, grob eingestellt, wobei beispielsweise Tabellenwerte zurundegelegt werden können. Schwankungen der Resonanzfrequenz werden nicht ausgeglichen, d. h., es wird kein Regelalgorithmus verwendet. Häufig muss der eingestellte Frequenzwert nur ungefähr einem vorgegebenen Sollwert entsprechen, d. h., geringe konstante Abweichungen vom Sollwert aber auch zeitliche Schwankungen sind erlaubt. Der Momentanwert der Resonanz- bzw. Lokaloszillatorfrequenz zu einem definierten Zeitpunkt muss aber häufig für spätere Berechnungen genau bekannt sein. Mit dem Frequenzzähler 20 wird daher der Istwert der Frequenz gemessen und der Steuereinheit 21 zugeführt.

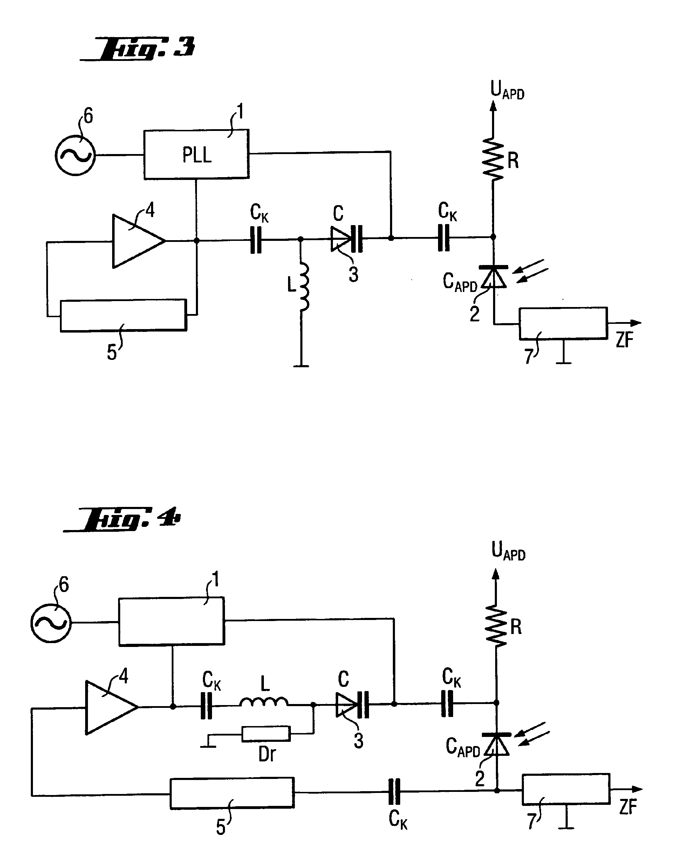

Die Fig. 3 zeigt eine Variante des LC-Oszillators. Hierbei wird die Kapazität C der Kapazitätsdiode 3 zur Sperrschichtkapazität der APD 2 in Serie geschaltet. Diese Serienschaltung bildet mit der Induktivität L einen Parallelresonanzkreis. Über die Induktivität L wird die Anode der Kapazitätsdiode 3 gleichspannungsmässig auf 0 Volt, d. h. auf Masse gelegt. Die positive Steuerspannung der PLL-Schaltung 1 wird wieder der Kathode der Kapazitätsdiode 3 zugeführt.

Die Fig. 4 veranschaulicht einen weiteren Serienschwingkreis bestehend aus Induktivität L, der Kapazität C der Kapazitätsdiode und der APD-Sperrschichtkapazität C_{APD}. Über eine Drossel Dr wird die Anode der Kapazitätsdiode 3 gleichspannungsmäßig auf Massepotential gelegt.

Der Vorteil der Anordnungen nach Fig. 3 und 4 ist der, dass bei notwendigen relativ großen Diodenkapazitäten C (z. B. 10 mal größer als C_{APD}) die Spannungsamplitude über der Kapazitätsdiode 3 geringer ist als bei der Beschaltung gemäß Fig. 1 bzw. Fig. 2. Bei großen Amplituden ist die Kapazitätsdiode 3 bei einer Halbwelle des Lokaloszillatorsignals in Durchlassrichtung geschaltet. Hierdurch wird die Amplitude begrenzt und es entstehen starke Oberwellenanteile im Lokaloszillatorsignal. Zur Reduzierung der Amplitude an der Kapazitätsdiode muss daher bei dem Ausführungsbeispiel in Fig. 1 zur Diodenkapazität C in der Regel zusätzlich eine weitere Kapazität (nicht gezeigt) in Serie geschaltet werden. Dies entspricht einem kapazitiven Spannungsteiler. Durch diese Maßnahme wird aber die effektive Kapazität dieser Serienschaltung klein, so dass auch der durchstimmbare Frequenzbereich des Resonanzkreises eingeschränkt wird.

Speziell bei der Anordnung in Fig. 4 wirkt sich vorteilhaft aus, dass die parasitären induktiven Anteile der APD 2, der Kapazitätsdiode 3 und der Koppelkondensatoren, welche aus den Zuleitungen hervorgehen, ebenfalls in den LC-Schwingkreis eingebunden sind. Da somit weniger Nebenresonanzen entstehen, wirkt sich dies positiv auf den Durchstimmbereich aus.

Bei den Anordnungen nach Fig. 3 und 4 ist zu beachten, dass durch die Serienschaltung der variablen Kapazität C der Kapazitätsdiode 3 und der Sperrschichtkapazität C_{APD} der APD 2 - aufgrund der kleinen Sperrschichtkapazität von z. B. 2 pF - der variable Bereich der effektiven Resonatorkapazität, d. h. die Serienschaltung aus C und C_{APD}, wie bei der Beschaltung nach Fig. 1 sehr klein werden kann. Hierdurch wird der Frequenzdurchstimmbereich des Schwingkreises eingeschränkt. Zudem wird die Amplitude der Spannung an der APD 2 durch den kapazitiven Spannungsteiler bestehend aus C und C_{APD} aufgrund der variablen Kapazität C abhängig von der Steuerspannung der PLL.

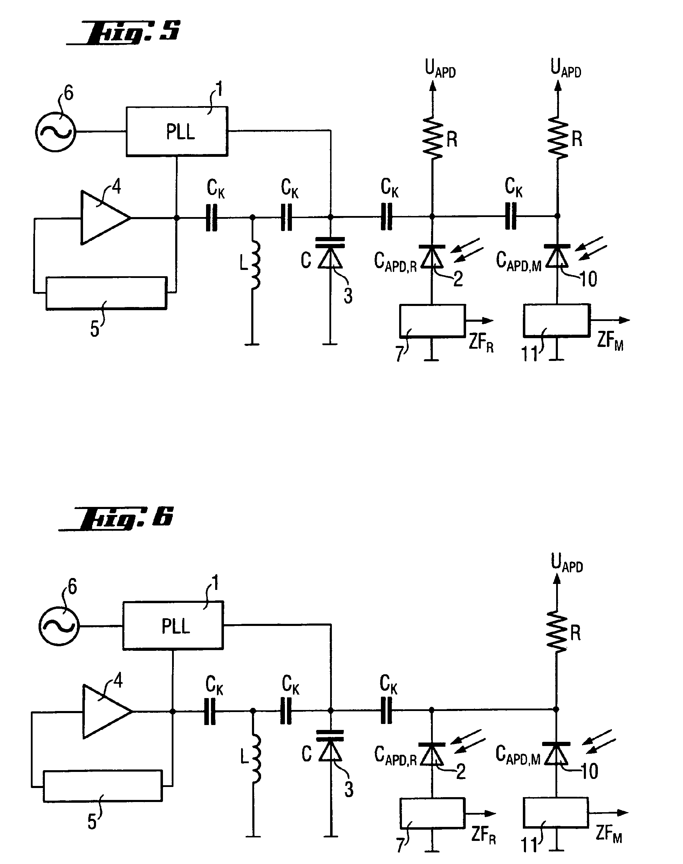

Die Fig. 5 veranschaulicht eine weitere ergänzte Variante der grundsätzlichen Schaltungsanordnung nach Fig. 1. Bei dieser Schaltungsanordnung wird der beschriebene PLL-stabilisierte LC-Oszillator durch eine HF-signalmäßige Parallelschaltung einer ersten Sperrschichtkapazität C_{APD,R} der in diesem Fall als Referenzempfänger eines optoelektronischen Distanzmessgeräts dienenden APD 2, der Sperrschichtkapazität C_{APD,M} einer als Messsignalempfänger verwendeten APD 10, der Kapazität C der Kapazitätsdiode 3 sowie der Induktivität L gebildet. Die APD 2 des Referenzempfängers empfängt das von einem Laserdiodensender (nicht gezeigt) emittierte sinusförmige intensitätsmodulierte Licht direkt nach dem Durchlaufen einer Referenzstrecke mit bekannter optischer Weglänge. Die APD 10 des Messempfängers detektiert das vom entfernten Messobjekt zurückgestreute ebenfalls sinusförmig intensitätsmodulierte Licht. Die beiden in den APDs 2, 10 generierten elektrischen Signale werden durch Direktmischung mit dem aus dem LC-Oszillator hervorgehenden Lokaloszillatorsignal in den (vergleichsweise) niederfrequenten Zwischenfrequenzbereich konvertiert. Über zugeordnete Tiefpassfilter 7 bzw. 11 lässt sich das ZF-Referenzsignal ZF_{R} bzw. das ZF-Messsignal ZF_{M} extrahieren. Durch Bestimmung der Phasendifferenz beider Zwischenfrequenzsignale kann die zu messende Distanz ermittelt werden. Phasenfehler, die vom Laserdiodensender erzeugt werden, werden durch diese Differenzbildung eliminiert. Es wird insoweit auf die bereits erwähnte und in der DE-Patentanmeldung Nr. 100 06 493.0 beschriebene optoelektronische Entfernungsmesseinrichtung verwiesen.

Falls es nicht darauf ankommt, dass die Verstärkungfaktoren der APD 10 des Messempfängers und der APD 2 des Referenzempfängers über ihre Sperrschichtspannungen gesondert einstellbar sein müssen, lassen sich die beiden APDs nach dem Ausführungsbeispiel in Fig. 6 sowohl HF-signalmäßig als auch gleichspannungsmäßig parallel schalten.

Entscheidend bei der Schaltungsanordnung nach Fig. 5 bzw. 6 ist, dass durch eine HF-signalmäßige Parallelschaltung der APD 10 des Messzweigs und der APD 2 des Referenzzweigs das gemeinsame Spannungssignal des Lokaloszillators phasengleich auf die jeweiligen Sperrschichten der APDs 2, 10 übertragen wird, falls die Bahnwiderstände der APDs vernachlässigbar sind. Da die Bahnwiderstände bei Silizium-APDs in der Regel kleiner sind als 0,1 Ω ist diese Voraussetzung in der Praxis auch gegeben. Die Phase des Lokaloszillatorsignals wird nur durch die Summenkapazität der Parallelschaltung C ∥ C_{APD,R} ∥ C_{APD,M} beeinflusst und nicht durch die einzelnen Sperrschichtkapazitäten der APDs 2, 10, welche abhängig sind von Umgebungseinflüssen und Exemplarstreuungen. Bei der Direktmischung findet der Mischprozess in der inneren Stromquelle der jeweiligen APD statt, so dass auch das hochfrequente Empfangssignal nicht von der Sperrschichtkapazität der betreffenden APD und anderen externen parasitären Kapazitäten beeinflusst wird. Zudem ist das frequenzkonvertierte ZF-Signal so niederfrequent, dass die von Umgebungseinflüssen und Exemplarstreuungen abhängige Sperrschichtkapazität hierfür keine Rolle spielt. Da also im Falle eines Distanzmessgeräts die APD 10 des Messzweigs und die APD 2 des Referenzzweigs mit dem gleichen Lokaloszillator beaufschlagt werden und Schwankungen der Summenkapazität sich für beide Zweige gleichermaßen auswirken, kann durch Bilden der Differenz der Phasen der jeweiligen ZF-Signale in gewissen Grenzen eine Fehlerkompensation erreicht werden. Eine ganz exakte Kompensation ist allerdings nicht möglich, da die Koppelkapazitäten sowie die Anschlusskapazitäten der APDs für das Lokaloszillatorsignal weitere, jedoch nur sehr geringe Phasenfehler implizieren. Auch Phasenänderungen im Empfangssignal, welche durch unterschiedliche Driftzeiten der Ladungsträger in der Sperrschicht der jeweiligen APD entstehen, lassen sich nicht kompensieren. Gleichwohl kann aber durch Verwendung der Schaltungsanordnung nach Fig. 5 bzw. 6 eine erhebliche Phasenfehlerquelle, d. h. das Verhalten der Sperrschichtkapazitäten eliminiert werden, so dass insbesondere bei der optoelektronischen Distanzmessung eine Fehlerreduzierung erreicht wird.

Vorteilhaft ist aber, dass dies nur für die Hochfrequenzsignale der Schaltung und nicht für die weniger kritischen niederfrequenten ZF-Signale gilt, für die parasiäre Kapazitäten meist vernachlässigbar sind. Für deren Verstärkung werden jedoch in der Regel im Mess- und Referenzzweig Zwischenfrequenzverstärker verwendet. Bei stark unterschiedlichen Signalamplituden müssen gegebenenfalls auch die Verstärkungen unterschiedlich gewählt werden, so dass die Signalphasen in beiden Zweigen verschieden beeinflusst werden können. Exemplarstreuungen der ZF-Verstärker (nicht gezeigt) können zusätzliche Fehler produzieren. Diese Phasenfehler müssen dann entweder rechnerisch berücksichtigt werden oder lassen sich mit der Anordnung, wie sie in der DE-Patentanmeldung Nr. 100 06 493.0 beschrieben ist, automatisch eliminieren.

Von besonderem Vorteil ist, dass die Induktivität L für das ZF-Signal einen guten Kurzschluss darstellt, so dass Übersprechen der ZF-Signale vom Referenz- auf den Messsignalzweig stark reduziert wird. Wichtig ist hierbei nicht so sehr die Kompensation der Kapazitäten durch die jeweilige Kapazitätsdiode und den LC-Schwingkreis, sondern die Tatsache, dass durch die erfindungsgemäße Parallelschaltung beide APD-Sperrschichten mit einem phasengleichen Lokaloszillatorsignal beaufschlagt werden, also durch Differenzbildung Phasenschwankungen kompensiert werden können. Die Kompensation der Kapazitäten ist in diesem Zusammenhang nur für die Erzeugung der konstanten Resonanzfrequenz von Bedeutung.

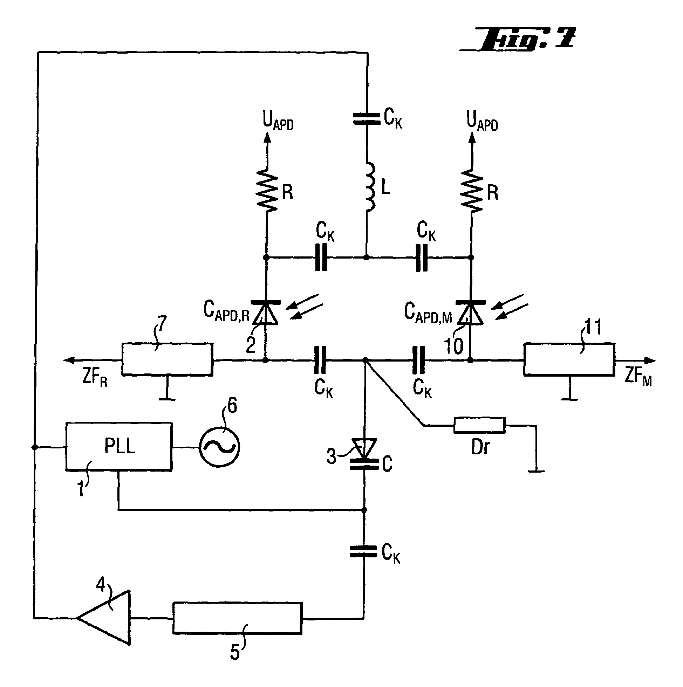

Bei dem Ausführungsbeispiel gemäß Fig. 7 sind die Sperrschichtkapazitäten C_{APD,R} und C_{APD,M} der HF-signalmäßig parallel geschalteten Avalanche-Fotodioden 2 und 10, beispielsweise eines Referenz- und Messempfängers in einen LC-Serienresonanzkreis eingebunden. Der LC-Kreis wird dabei durch die Induktivität L durch die zu L in Serie geschaltete Kapazität C der Kapazitätsdiode 3 und durch die zu L in Serie geschaltete Summenkapazität C_{APD,R} + C_{APD,M} der parallelgeschalteten APDs 2, 10 gebildet. Die Koppelkapazitäten C_{K} sind hierbei wieder HF-signalmäßige Kurzschlüsse. Die Tiefpassfilter 7 und 11 dienen der Auskopplung der ZF-Signale des Mess- und Referenzkanals und erzeugen an den Anoden der APDs 2, 10 einen Gleichspannungsanteil von nahezu 0 Volt, indem über einen relativ hochohmigen Widerstand eine Verbindung nach Masse hergestellt wird. Die Tiefpassfilter 7, 10 sind für die HF-Signale, d. h. für die Empfangssignale der APDs 2, 10 und für das aus dem LC-Oszillator hervorgehende Lokaloszillatorsignal, undurchlässig. Der Verstärker 4 führt zusammen mit dem Rückkoppelungsnetzwerk 5 wieder zu einem stabilen Betrieb des LC-Oszillators mit konstanter Amplitude. Die Resonanzfrequenz wird auch in diesem Beispiel in oben beschriebener Weise von der PLL-Schaltung 1 durch Beeinflussung der Sperrspannung an der Kapazitätsdiode 3 geregelt. Über die Drossel Dr wird die Anode der Kapazitätsdiode gleichspannungsmäßig geerdet, d. h. auf Masse gelegt. Für die HF-Signale ist die Drossel Dr undurchlässig, und für die niederfrequenten ZF-Signale stellt sie einen Kurzschluss dar, so dass ein Übersprechen der ZF-Signale vom Referenz- auf den Messsignalzweig auch hier stark reduziert wird. Die Koppelkapazitäten C_{K} stellen für die niederfrequenten ZF-Signale eine hohe Impedanz dar. Falls es nicht darauf ankommt, dass die Verstärkungfaktoren der APD 10 des Messempfängers und der APD 2 des Referenzempfängers über ihre Sperrschichtspannungen gesondert einstellbar sein müssen, können die beiden APDs 2, 10 ähnlich wie in Fig. 6 auch gleichspannungsmäßig parallel geschaltet werden, indem die Koppelkapazitäten an den Kathoden der APDs 2, 10 in Fig. 7 durch leitende Verbindungen ersetzt werden.

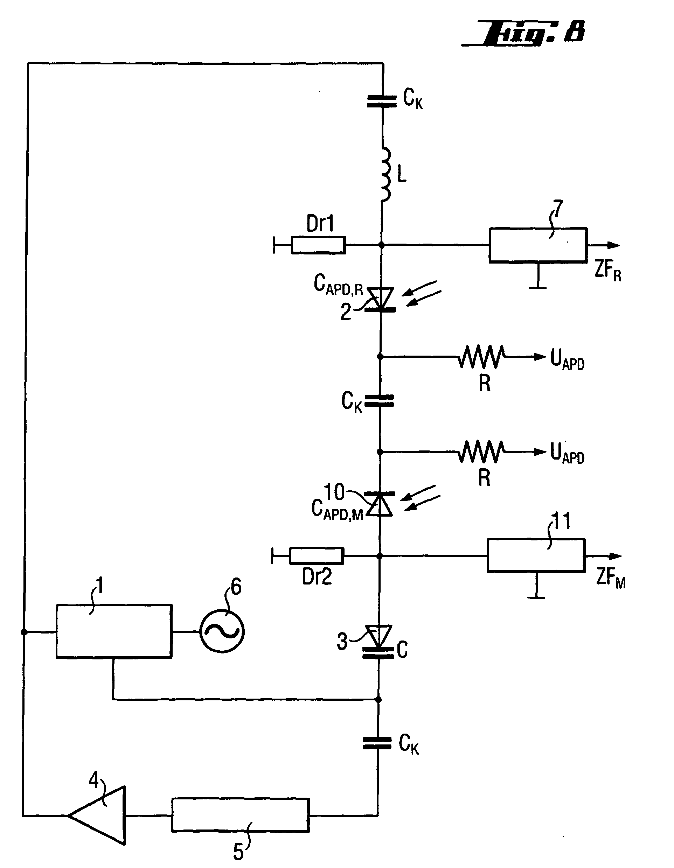

Bei dem Ausführungsbeispiel nach Fig. 8 sind die Sperrschichtkapazitäten C_{APD,R} und C_{APD,M} der HF-signalmäßig in Serie geschalteten Avalanche-Fotodioden 2 und 10 beispielsweise des Referenz- und Messempfängers in einem LC-Serienresonanzkreis eingebunden. Dieser Kreis besteht aus der Induktivität L, der zu L in Serie geschalteten Kapazität C der Kapazitätsdiode 3 und der ebenfalls zu L in Serie geschalteteten Kapazitäten C_{APD,R} sowie C_{APD,M} der APDs 2, 10. Auch hier stellen die Koppelkapazitäten C_{K} Kurzschlüsse für die HF-Signale dar. Die Tiefpassfilter 7 und 11 dienen der Auskopplung der ZF-Signale des Mess- und Referenzkanals. Für die HF-Signale, also für die Empfangssignale der APDs 2, 10 und für das aus dem IC-Oszillator hervorgehende Lokaloszillatorsignal, sind sie undurchlässig. Der Verstärker 4 bewirkt zuammen mit dem Rückkoppelungsnetzwerk 5 einen stabilen Betrieb des Oszillators mit konstanter Amplitude. Die Resonanzfrequenz wird auch in diesem Beispiel von der PLL-Schaltung 1 durch Beeinflussung der Sperrspannung an der Kapazitätsdiode 3 geregelt. Über Drosseln Dr1 und Dr2 werden die Anode der Kapazitätsdiode 3 sowie die Anoden der APDs 2 und 10 gleichspannungsmäßig geerdet, d. h. auf Masse geführt. Für die HF-Signale sind die Drosseln undurchlässig, und für die niederfrequenten ZF-Signale stellen sie einen Kurzschluss dar, so dass ein Übersprechen der ZF-Signale vom Referenz- auf den Messsignalzweig stark reduziert wird. Die Koppelkapazitäten C_{K} besitzen für die niederfrequenten ZF-Signale eine hohe Impedanz. Falls es nicht darauf ankommt, dass die Verstärkungsfaktoren der APD 10 des Messempfängers und APD 2 des Referenzempfängers über ihre Sperrschichtspannungen separat einstellbar sein müssen, können die Kathoden der beiden APDs 2, 10 auch gleichspannungsmäßig verbunden werden, indem die Koppelkapazität zwischen ihnen in Fig. 8 durch eine leitende Verbindung ersetzt wird.

Die Vorteile und Nachteile der Varianten in Fig. 7 und 8 im Vergleich zur Ausführungsform der Erfindung nach Fig. 6 wurden bereits bei der Beschreibung der entsprechenden Ausführungsbeispiele in Fig. 3 und 4 ausführlich diskutiert. Dabei ist ein Vorteil in der geringeren Spannungsamplitude über der Kapazitätsdiode 3 begründet. Speziell bei der Anordnung nach Fig. 8 sind zudem die parasitären induktiven Anteile der APDs 2, 10, der Kapazitätsdiode 3 und der Koppelkondensatoren C_{K} Bestandteil des LC-Schwingkreises, so dass weniger Nebenresonanzen entstehen. Bei den Anordnungen nach Fig. 7 und 8 ist jedoch anzumerken, dass durch die Serienschaltung der Kapazitätsdiode 3 mit den Sperschichtkapazitäten der APDs 2, 10 - aufgrund der kleinen APD-Kapazität von z. B. 2 pF - der variable Bereich der effektiven Resonatorkapazität klein werden kann, so dass der Frequenzdurchstimmbereich des Schwingkreises eingeschränkt ist. Außerdem wird die Amplitude der APD-Spannung durch den kapazitiven Spannungsteiler und der variablen Kapazität C der Kapazitätsdiode 3 abhängig von der Steuerspannung der PLL-Schaltung 1. Bei der Variante nach Fig. 8 sollte weiter beachtet werden, dass bei unterschiedlichen Sperrschichtkapazitäten C_{APD,R} und C_{APD,M} sich das Lokaloszillatorsignal unsymmetrisch auf die jeweiligen APDs 2, 10 überträgt. Hierdurch werden Exemplarstreuungen und Umgebungseinflüsse auf die Empfangsphase weniger gut kompensiert als bei den anderen Beispielen. Zudem wird durch die Serienschaltung der APD-Sperschichtkapazitäten durch den hieraus hervorgehenden kapazitiven Spannungsteiler die Spannungsamplitude an den jeweiligen APDs 2, 10 halbiert. Für einen hohen Wirkungsgrad der Direktmischung sollte die Amplitude des LO-Signals jedoch mögichst hoch sein.

Für die Zuammenschaltung zu einem LC-Schwingkreis sind noch weitere Kombinationen denkbar. Beispielsweise kann ein Parallelschwingkreis aus einer Induktivität und der Serienschaltung einer Kapazitätsdiode mit in Serie geschalteten APD-Sperrschichtkapazitäten verwendet werden. Auch ein Parallelschwingkreis aus einer Induktivität und der Serienschaltung einer Kapazitätsdiode mit parallel geschalteten APD-Sperrschichtkapazitäten wäre möglich. Die Verschaltung der APDs kann je nach Anwendung hochfrequenzsignalmäßig oder gleichspannungsmäßig erfolgen. Natürlich kann bei allen Ausführungsbeispielen anstatt des PLL-geregelten Lokaloszillators auch die digitale Steuerereinheit nach Fig. 2 verwendet werden, wobei gemäß der Beschreibung zu Fig. 2 sowohl ein geregeltes als auch ein ungeregeltes System möglich ist.

Ein wesentlicher Vorteil der erfindungsgemäßen Schaltung eines Lokaloszillators ergibt sich aus Folgendem:
Eine APD ist eine Stromquelle, die einen intern generierten Fotostrom liefert. Parallel zu dieser Stromquelle liegt die Sperrschichtkapazität der APD. Bei hohen Frequenzen wird durch diese Sperrschichtkapazität das Signal kurzgeschlossen, so dass ein Tiefpassverhalten resultiert. Auch das Lokaloszillatorsignal "sieht" diese Sperrschichtkapazität und wird durch sie ebenfalls auf Masse kurzgeschlossen. Dies ist aber nur der Fall, wenn das Lokaloszillatorsignal z. B. über einen Verstärker zugeführt wird. In dem beschriebenen Fall und gemäß der Erfindung, bei dem das Lokaloszillatorsignal durch den LC-Resonanzkreis selbst gebildet wird, wird der kapazitive Einfluss und damit auch das aus der jeweiligen Sperrschichtkapazität hervorgehende Tiefpassverhalten durch die parallel bzw. in Serie geschaltete Induktivität L eliminiert, d. h. weggestimmt. Die Sperrschichtkapazität wird in den Resonanzkreis integriert und kann somit kein Tiefpassverhalten mehr erzeugen. Das Tiefpassverhalten wird nur noch durch die Driftzeiten der generierten Ladungsträger innerhalb des Halbleiters gebildet.

Ein Lokaloszillator mit erfindungsgemäßen Merkmalen ist also durch folgende vorteilhafte Eigenschaften ausgezeichnet:
- Mögliche Störung durch Übersprechen und Einstreuung externer elektromagnetischer Störleistungen sind aufgrund der möglichen sehr kleinen Strukturen gering.
- Im Pfad des Empfangssignals, beispielsweise eines Messsignals, sind keine für EMI empfindliche Hochfrequenzsignale, -komponenten und -strukturen vorhanden, da das Messsignal bzw. das APD-Empfangssignal schmalbandig sind.
- Die über der oder die APDs erzeugten Ausgangssignale sind niederfrequent, d. h. beispielsweise im Bereich von 10 kHz bis 100 kHz, und lassen sich damit unproblematisch weiterverarbeiten und rauscharm verstärken. Es entstehen keine Probleme mit einer eventuellen Anpassung, der Strukturgröße von Baugruppen, Abstrahlung, Übersprechen, EMI und sonstigen parasitären Effekten.
- Der Bauteilbedarf ist reduziert und damit prinzipiell auch die Systemkosten.
- Der Stromverbrauch ist im Vergleich zu bekannten Lösungen mit Hochfrequenzübertragung oder Systemen mit notwendiger Impedanzanpassung deutlich verringert.
- Die Verlustleistung an der jeweiligen APD-Kathode ist gering aufgrund des Leerlaufbetriebs bei hoher Spannungsamplitude am LC-Resonatorkreis.
- Mögliche störende Umgebungseinflüsse, wie Temperatur, stark schwankende Empfangsleistung, variierende Sperrschichtspannung und Exemplarstreuungen auf das Signalphasenverhalten sind durch die Eliminierung parasitärer Kapazitäten automatisch kompensiert.
- Ein definierter Systemzustand im Empfangs- und Signalverarbeitungsteil stellt sich automatisch ein, unabhängig von Exemplarstreuungen und eventuellen Umgebungseinflüssen.
- Bei Anwendung der Erfindung in einem optoelektronischen Distanzmessgerät wird die Messgenaugikeit deutlich verbessert.
- Automatische Eliminierung des tiefpassbegrenzenden Verhaltens durch Wegstimmen der Schaltungskapazitäten unabhängig von Umgebungseinflüssen und Exemplarstreuungen.
- Es lässt sich eine definierte Lokaloszillatorfrequenz gewährleisten, die unabhängig ist von möglichen Exemplarstreuungen und Umgebungseinflüssen.
- Die Lokaloszillatorfrequenz und das Signalphasenverhalten hängen nur von der Frequenz des Referenzoszillators und dem Teilerverhältnis der PLL-Schaltung ab.
- Unterschiedliche Phasen- bzw. Laufzeiten werden im Falle einer optoelektronischen Distanzmesseinrichtung beim Mess- und Referenzempfänger durch die HF-signalmäßige Parallelschaltung der Referenz-APD und der Mess-APD in einem LC-Schwingkreis eliminiert.

## Patentansprüche

1. Lokaloszillator zur Erzeugung eines Schmalbandigen HF-Signals mit einer in Sperrrichtung vorgespannten Avalanche-Fotodiode (APD 2), welche zur Direktmischung des HF-Signals mit einem aus einem auf die Avalanche-Fotodiode (APD 2) auftreffenden Lichtsignal erzeugten ersten Empfangssignal dient, wobei die Avalanche-Fotodiode (APD 2) mit ihrer Sperrschichtkapazität (CAPD) in einen steuerbaren HF-Resonanzkreis einbezogen ist, dessen die Frequenz des HF-Signals bestimmende Resonanzfrequenz durch wählbare Einstellungen einer von einem Referenzoszillator (6) beaufschlagten Steuereinheit bestimmt ist

2. Lokaloszillator nach Anspruch 1, **dadurch gekennzeichnet, dass** die Steuereinheit eine PLL-Schaltung (1) zur Frequenz- bzw. Phasenregelung ist, deren einstellbares Teilerverhältnis zusammen mit der Frequenz des Referenzoszillators (6) die Frequenz des HF-Resonankreises bestimmt.

3. Lokaloszillator nach Anspruch 1, **dadurch gekennzeichnet, dass** die Steuereinheit eine digitale Recheneinheit ist, die mit von dieser Recheneinheit generierten Steuersignalen die Frequenz des HF-Resonanzkreises einstellt, und auf Basis der Frequenz des Referenzoszillators den Istwert der Frequenz des HF-Resonanzkreises ermittelt.

4. Lokaloszillator nach Anspruch 3, **dadurch gekennzeichnet, dass** die digitale Recheneinheit mit der Frequenz des Referenzoszillators (6) und dem ermittelten Istwert der Frequenz des HF-Resonanzkreises über einen Regler und von der digitalen Recheneinheit generierten Steuersignalen den Sollwert der Frequenz des HF-Resonanzkreises bestimmt.

5. Lokaloszillator nach Anspruch 4, **dadurch gekennzeichnet, dass** der Regler durch ein Rechenprogramm realisiert ist.

6. Lokaloszillator nach Anspruch 2 oder 3, **dadurch gekennzeichnet, dass** der HF-Resonanzkreis ein zur Sperrschichtkapazität (C_{APD}) parallel oder in Serie geschalteter HF-Resonanzkreis mit steuerbarer Kapazität (C) ist.

7. Lokaloszillator nach Anspruch 6, **dadurch gekennzeichnet, dass** die steuerbare Kapazität eine Kapazitätsdiode (3) ist.

8. Lokaloszillator nach Anspruch 2 oder 3, **dadurch gekennzeichnet, dass** der HF-Resonanzkreis ein zur Sperrschichtkapazität (C_{APD}) parallel oder in Serie geschalteter HF-Resonanzkreis mit steuerbarer Induktivität ist.

9. Lokaloszillator nach Anspruch 2 oder 3 und/oder 6 oder 8, **dadurch gekennzeichnet, dass** der HF-Resonanzkreis durch einen Resonator und die steuerbare Kapazität und/oder die steuerbare Induktivität zusammen mit der Sperrschichtkapazität (C_{APD}) der Avalanche-Fotodiode (APD 2) gebildet ist.

10. Lokaloszillator nach Anspruch 9, **dadurch gekennzeichnet, dass** der Resonator ein LC-Serien- oder LC-Parallelresonanzkreis ist.

11. Lokaloszillator nach Anspruch 9, **dadurch gekennzeichnet, dass** der Resonator ein Hohlraumresonator ist.

12. Lokaloszilltor nach Anspruch 9, **dadurch gekennzeichnet, dass** der Resonator ein Leitungsresonator ist.

13. Lokaloszillator nach Anspruch 9, **dadurch gekennzeichnet, dass** der Resonator ein Quarzresonator oder ein SAW (surface acoustic wave)-Resonator ist.

14. Lokaloszillator nach Anspruch 9, **dadurch gekennzeichnet, dass** der Resonator ein dielektrischer Keramikresonator ist.

15. Lokaloszillator nach Anspruch 2 oder 3, **gekennzeichnet durch** einen mit dem HF-Resonanzkreis verbundenen rückgekoppelten Verstärker (4, 5) zum Ausgleichen von Verlusten und zur Aufrechterhaltung einer Oszillation konstanter Amplitude des HF-Resonanzkreises.

16. Lokaloszillator nach Anspruch 1, **gekennzeichnet durch** einen mit dem Mischsignalausgang der Avalanche-Fotodiode verbundenen Tiefpass (7) mit einer über einem gewünschten ZF-Signal liegenden Grenzfrequenz.

17. Lokaloszillator nach einem der vorstehenden Ansprüche, **gekennzeichnet durch** eine weitere ebenfalls in Sperrrichtung vorgespannte Avalanche-Fotodiode (APD 10), die ein zweites **durch** Direktmischung in einen anderen Frequenzbereich umzusetzendes Empfangssignal erzeugt und deren Sperrschichtkapazität (C_{APD,M}) zur Sperrschichtkapazität (C_{APD,R}) der ersten Avalanche-Fotodioe (APD 2) und zum LC-Resonanzkreis parallel geschaltet ist.

18. Lokaloszillator nach einem der vorstehenden Ansprüche 1 bis 16, **gekennzeichnet durch** eine weitere ebenfalls in Sperrichtung vorgespannte Avalanche-Fotodiode (APD 10), die ein zweites **durch** Direktmischung in einen anderen Frequenzbereich umzusetzendes Empfangssignal erzeugt und deren Sperrschichtkapazität (C_{APD,M}) mit der Sperschichtkapazität (C_{APD,R}) der ersten Avalance-Fotodiode (APD 2) parallel geschaltet ist, wobei die Gesamtkapazität (C_{APD,M} + C_{APD,R}) dieser Parallelschaltung zum LC-Serienresonanzkreis in Serie geschaltet ist.

19. Lokaloszillator nach einem der vorstehenden Ansprüche 1 bis 16, **gekennzeichnet durch** eine weitere ebenfalls in Sperrrichtung vorgespannte Avalanche-Fotodiode (APD 10), die ein zweites **durch** Direktmischung in einen anderen Frequenzbereich umzusetzendes Empfangssignal erzeugt, und deren Sperrschichtkapazität (C_{APD,M}) mit der Sperrschichtkapazität (C_{APD,R}) der ersten Avalanche-Fotodiode (APD 2) und mit dem LC-Serienresonanzkreis in Serie geschaltet ist.

20. Lokaloszillator nach einem der vorstehenden Ansprüche 1 bis 16, **gekennzeichnet durch** eine weitere ebenfalls in Sperrrichtung vorgespannte Avalanche-Fotodiode (APD 10), die ein zweites **durch** Direktmischung in einen anderen Frequenzbereich umzusetzendes Empfangssignal erzeugt, und deren Sperrschichtkapazität (C_{APD,M}) mit der Sperrschichtkapazität (C_{APD,R}) der ersten Avalanche-Fotodiode (APD 2) in Serie geschaltet ist, wobei die Gesamtkapazität der Serienschaltung zum LC-Parallelresonanzkreis parallel geschaltet ist.

21. Anwendung des Lokaloszillators nach einem der vorstehenden Ansprüche in einem optoelektronischen Distanzmessgerät, bei dem mindestens eine Avalanche-Fotodiode als Empfangselement für ein optisches Mess- und/oder Referenzsignal verwendet ist.

## Claims

1. Local oscillator for generating a narrow-band HF signal with a reverse-biased avalanche photodiode (APD 2) for direct mixing of the HF signal with a first received signal generated from a light signal impinging on the avalanche photodiode (APD 2), wherein the avalanche photodiode (APD 2) is included with its junction capacitance (CAPD) in a controllable HF resonant circuit whose resonance frequency determining the frequency of the HF signal is determined by selectable settings of a control unit acted on by a reference oscillator (6)

2. Local oscillator according to Claim 1, **characterized in that** the control unit is a PLL circuit (1) for frequency or phase regulation whose adjustable divider ratio together with the frequency of the reference oscillator (6) determines the frequency of the HF resonant circuit.

3. Local oscillator according to Claim 1, **characterized in that** the control unit is a digital data processor which sets the frequency of the HF resonant circuit with control signals generated by the said data processor and determines the actual value of the frequency of the HF resonant circuit on the basis of the frequency of the reference oscillator.

4. Local oscillator according to Claim 3, **characterized in that** the digital data processor determines the required value of the frequency of the HF resonant circuit with the frequency of the reference oscillator (6) and the determined actual value of the frequency of the HF resonant circuit via a controller and control signals generated by the digital data processor.

5. Local oscillator according to Claim 4, **characterized in that** the controller is realized by a computer program.

6. Local oscillator according to Claim 2 or Claim 3, **characterized in that** the HF resonant circuit is an HF resonant circuit with controllable capacitance (C) connected in parallel or in series to the junction capacitance (CAPD).

7. Local oscillator according to Claim 6, **characterized in that** the controllable capacitance is a variable capacitance diode (3).

8. Local oscillator according to Claim 2 or Claim 3, **characterized in that** the HF resonant circuit is an HF resonant circuit with controllable inductance connected in parallel or in series to the junction capacitance (CAPD).

9. Local oscillator according to Claims 2 or 3 and/or Claims 6 or 8, **characterized in that** the HF resonant circuit is formed by a resonator and the controllable capacitance and/or controllable inductance together with the junction capacitance (CAPD) of the avalanche photodiode (APD 2).

10. Local oscillator according to Claim 9, **characterized in that** the resonator is an LC-series or LC-parallel resonant circuit.

11. Local oscillator according to Claim 9, **characterized in that** the resonator is a cavity resonator.

12. Local oscillator according to Claim 9, **characterized in that** the resonator is a line resonator.

13. Local oscillator according to Claim 9, **characterized in that** the resonator is a quartz resonator or SAW (surface acoustic wave) resonator.

14. Local oscillator according to Claim 9, **characterized in that** the resonator is a dielectric ceramic resonator.

15. Local oscillator according to Claim 2 or Claim 3, **characterized by** a feedback amplifier (4, 5) connected to the HF resonant circuit for compensating losses and maintaining oscillation with constant amplitude of the HF resonant circuit.

16. Local oscillator according to Claim 1, **characterized by** a low-pass filter (7) connected to the mixed-signal output of the avalanche photodiode, with a boundary frequency above a desired IF signal.

17. Local oscillator according to any one of the preceding claims, **characterized by** a further avalanche photodiode (APD 10), likewise reverse-biased, which generates a second received signal to be converted by direct mixing into another frequency range and whose junction capacitance (CAPD,M) is connected in parallel to the junction capacitance (CAPD,R) of the first avalanche photodiode (APD 2) and to the LC resonant circuit.

18. Local oscillator according to any one of the preceding Claims 1 to 16, **characterized by** a further avalanche photodiode (APD 10), likewise reverse-biased, which generates a second received signal to be converted by direct mixing into another frequency range and whose junction capacitance (CAPD,M) is connected in parallel to the junction capacitance (CAPD,R) of the first avalanche photodiode (APD 2), the total capacitance (CAPD,M + CAPD,R) of this parallel circuit being connected in series to the LC series resonant circuit.

19. Local oscillator according to any one of the preceding Claims 1 to 16, **characterized by** a further avalanche photodiode (APD 10), likewise reverse-biased, which generates a second received signal to be converted by direct mixing into another frequency range, and whose junction capacitance (CAPD,M) is connected in series to the junction capacitance (CAPD,R) of the first avalanche photodiode (APD 2) and to the LC series resonant circuit.

20. Local oscillator according to any one of the preceding Claims 1 to 16, **characterized by** a further avalanche photodiode (APD 10), likewise reverse-biased, which generates a second received signal to be converted by direct mixing into another frequency range, and whose junction capacitance (CAPD,M) is connected in series to the junction capacitance (CAPD,R) of the first avalanche photodiode (APD 2), the total capacitance of the series circuit being connected in parallel to the LC parallel resonant circuit.

21. Use of the local oscillator according to any one of the preceding claims in an optoelectronic distance-measuring instrument wherein at least one avalanche photodiode is used as receiving element for an optical measuring and/or reference signal.

## Revendications

1. Oscillateur local pour générer un signal HF à bande étroite avec une photodiode à avalanche (APD 2) polarisée en inverse, laquelle photodiode sert à mélanger directement le signal HF avec un premier signal de réception généré à partir d'un signal lumineux apparaissant sur la photodiode à avalanche (APD 2), dans lequel la photodiode à avalanche (APD 2) avec sa capacité de couche de déplétion (C_{APD}) est incorporée dans un circuit de résonance HF pouvant être commandé, dont la fréquence de résonance formant la fréquence du signal HF est déterminée par des réglages sélectionnables d'une unité de commande qui est mise en action par un oscillateur de référence (6).

2. Oscillateur local selon la revendication 1, **caractérisé en ce que** l'unité de commande est un circuit PLL (1) pour la régulation de fréquence ou la régulation de phase, dont le rapport de répartition réglable, conjointement avec la fréquence de l'oscillateur de référence (6), détermine la fréquence du circuit de résonance HF.

3. Oscillateur local selon la revendication 1, **caractérisé en ce que** l'unité de commande est une unité de calcul numérique qui règle la fréquence du circuit de résonance HF avec des signaux de commande générés par cette unité de calcul, et détermine la valeur réelle de la fréquence du circuit de résonance HF sur la base de la fréquence de l'oscillateur de référence.

4. Oscillateur local selon la revendication 3, **caractérisé en ce que** l'unité de calcul numérique détermine la valeur de consigne de la fréquence du circuit de résonance HF avec la fréquence de l'oscillateur de référence (6) et la valeur réelle déterminée de la fréquence du circuit de résonance HF, par l'intermédiaire d'un régulateur et de signaux de commande générés par l'unité de calcul numérique.

5. Oscillateur local selon la revendication 4, **caractérisé en ce que** le régulateur est réalisé par un programme informatique.

6. Oscillateur local selon la revendication 2 ou 3, **caractérisé en ce que** le circuit de résonance HF est un circuit de résonance HF avec une capacité pouvant être commandée (C), lequel circuit de résonance HF est raccordé en parallèle ou en série à la capacité de couche de déplétion (C_{APD}).

7. Oscillateur local selon la revendication 6, **caractérisé en ce que** la capacité pouvant être commandée est une diode à capacité (3).

8. Oscillateur local selon la revendication 2 ou 3, **caractérisé en ce que** le circuit de résonance HF est un circuit de résonance HF avec une inductance pouvant être commandée, lequel circuit de résonance HF est raccordé en parallèle ou en série à la capacité de couche de déplétion (C_{APD}).

9. Oscillateur local selon la revendication 2 ou 3 et/ou 6 ou 8, **caractérisé en ce que** le circuit de résonance HF est formé par un résonateur et la capacité pouvant être commandée et/ou l'inductance pouvant être commandée, conjointement avec la capacité de couche de déplétion (C_{APD}) de la photodiode à avalanche (APD 2).

10. Oscillateur local selon la revendication 9, **caractérisé en ce que** le résonateur est un circuit de résonance série LC ou parallèle LC.

11. Oscillateur local selon la revendication 9, **caractérisé en ce que** le résonateur est un résonateur à cavité.

12. Oscillateur local selon la revendication 9, **caractérisé en ce que** le résonateur est un résonateur de ligne.

13. Oscillateur local selon la revendication 9, **caractérisé en ce que** le résonateur est un résonateur à quartz ou un résonateur SAW (onde acoustique de surface).

14. Oscillateur local selon la revendication 9, **caractérisé en ce que** le résonateur est un résonateur céramique diélectrique.

15. Oscillateur local selon la revendication 2 ou 3, **caractérisé par** un amplificateur à rétroaction (4, 5) relié au circuit de résonance HF pour compenser des pertes et pour entretenir une oscillation à amplitude constante du circuit de résonance HF.

16. Oscillateur local selon la revendication 1, **caractérisé par** un passe-bas (7) relié à la sortie de signal de mélange de la photodiode à avalanche, ayant une fréquence de coupure supérieure à un signal ZF souhaité.

17. Oscillateur local selon l'une quelconque des revendications précédentes, **caractérisé par** une autre photodiode à avalanche (APD 10) également polarisée en inverse, laquelle photodiode génère un second signal de réception à convertir par mélange direct dans une autre plage de fréquences, et dont la capacité de couche de déplétion (C_{APD,M}) est raccordée en parallèle à la capacité de couche de déplétion (C_{APD,R}) de la première photodiode à avalanche (APD 2) et au circuit de résonance LC.

18. Oscillateur local selon l'une quelconque des revendications 1 à 16 précédentes, **caractérisé par** une autre photodiode à avalanche (APD 10) également polarisée en inverse, laquelle photodiode génère un second signal de réception à convertir par mélange direct dans une autre plage de fréquences, et dont la capacité de couche de déplétion (C_{APD,M}) est raccordée en parallèle à la capacité de couche de déplétion (C_{APD,R}) de la première photodiode à avalanche (APD 2), dans lequel la capacité totale (C_{APD,M} + C_{APD,R}) de ce circuit en parallèle est raccordée en série au circuit de résonance série LC.

19. Oscillateur local selon l'une quelconque des revendications 1 à 16 précédentes, **caractérisé par** une autre photodiode à avalanche (APD 10) également polarisée en inverse, laquelle photodiode génère un second signal de réception à convertir par mélange direct dans une autre plage de fréquences, et dont la capacité de couche de déplétion (C_{APD,M}) est raccordée en série à la capacité de couche de déplétion (C_{APD,R}) de la première photodiode à avalanche (APD 2) et au circuit de résonance série LC.

20. Oscillateur local selon l'une quelconque des revendications 1 à 16 précédentes, **caractérisé par** une autre photodiode à avalanche (APD 10) également polarisée en inverse, laquelle photodiode génère un second signal de réception à convertir par mélange direct dans une autre plage de fréquences, et dont la capacité de couche de déplétion (C_{APD,M}) est raccordée en série à la capacité de couche de déplétion (C_{APD,R}) de la première photodiode à avalanche (APD 2), dans lequel la capacité totale du circuit en série est raccordée en parallèle au circuit de résonance parallèle LC.

21. Utilisation de l'oscillateur local selon l'une quelconque des revendications précédentes dans un appareil de mesure de distance optoélectronique, dans laquelle au moins une photodiode à avalanche est utilisée comme élément de réception pour un signal de mesure et/ou de référence optique.
